# EUROPEAN PATENT APPLICATION

(11) **EP 4 460 163 A1**
(43) Date of publication of application: **06.11.2024**
(21) Application number: 23175648.7
(22) Date of filing: 26.05.2023
(51) Int. Cl.: H10B 41/10, H10B 41/20, H10B 41/50, H10B 43/10, H10B 43/20, H10B 43/50

(54) **SEMICONDUCTOR DEVICE AND METHOD OF FABRICATING THE SAME**

(30) Priority: 04.05.2023 US 202318312207
(71) Applicant: MACRONIX INTERNATIONAL CO., LTD., Hsinchu (TW)
(72) Inventor: Shen, Kuan-Yuan, Zhubei City, Hsinchu County (TW); Lee, Guan-Ru, 300 Hsinchu City (TW); Chiu, Chia-Jung, Zhubei City, Hsinchu County (TW)
(74) Representative: Kurig, Thomas

(57) **Abstract**

A semiconductor device includes a staircase structure (SC) and an extension part (EP, 94). The staircase structure (SC) is located on a dielectric substrate (100). The staircase structure (SC) includes a plurality of conductive layers (38, 38g, 138, 138g) and a plurality of insulating layers (54, 92) stacked alternately on each other. The extension part (EP, 94) is located at an end of the lower stair part (LP) of the staircase structure (SC). The resistance value of the extension part (EP, 94) is different from the resistance value of the plurality of conductive layers (38, 38g, 138, 138g).

## Description

### BACKGROUND

### Technical Field

The present disclosure relates to an integrated circuit and a method of fabricating the same, and particularly to a semiconductor device and a method of fabricating the same.

### Description of Related Art

Since a non-volatile memory has the advantage that stored data does not disappear at power-off, it becomes a widely used memory for a personal computer or other electronics equipment. Currently, the three-dimensional memory commonly used in the industry includes a NOR memory and a NAND memory. In addition, another type of three-dimensional memory is an AND memory, which may be applied to a multi-dimensional memory array with high integration and high area utilization, and has an advantage of a fast operation speed. Therefore, the development of a three-dimensional memory device has gradually become the current trend. However, there are still many challenges associated with the three-dimensional memory device.

### SUMMARY

The disclosure provides a semiconductor device, which can have a conduction path for charges to reduce the arc effect, and prevent various material layers and components on the dielectric substrate from being damaged by plasma bombardment.

According to an embodiment of the present disclosure, a semiconductor device includes a staircase structure and an extension part. The staircase structure is located on a dielectric substrate. The staircase structure includes a plurality of conductive layers and a plurality of insulating layers stacked alternately on each other. The extension part is located at the end of the lower stair part of the staircase structure. The resistance value of the extension part is different from the resistance value of the plurality of conductive layers.

According to an embodiment of the present disclosure, a method of fabricating a semiconductor device includes the following steps. A staircase structure is formed on a dielectric substrate, wherein the staircase structure includes a plurality of conductive layers and a plurality of insulating layers stacked alternately on each other. An extension part is formed at the end of the lower stair part of the staircase structure. The resistance value of the extension part is different from the resistance value of the plurality of conductive layers.

Based on the above, in the embodiment of the present disclosure, one or more semiconductor layers located at the lower part of the stacked structure can serve as a conduction path for charges to reduce the arc effect, and prevent the various material layers and components on the dielectric substrate from being damaged by plasma bombardment. Therefore, the yield of the process can be improved. In addition, the one or more semiconductor layers can be subjected to a subsequent replacement process to form one or more conductive layers, which can serve as gate layers or dummy gate layers.

### BRIEF DESCRIPTION OF THE DRAWINGS

FIG. 1A is a circuit diagram of a three-dimensional AND flash memory array according to some embodiments.
FIG. 1B is a partial perspective view of a part of the memory array in FIG. 1A.
FIG. 1C and FIG. 1D are cross-sectional views taken along the line I-I' of FIG. 1B.
FIG. 1E is a top view of the line II-II' of FIG. 1B, FIG. 1C, FIG. 1D.
FIG. 1F to FIG. 1I are schematic cross-sectional views of various staircase structures.
FIG. 2A to FIG. 2I are schematic cross-sectional views illustrating a method of fabricating a memory device according to an embodiment of the present disclosure.
FIG. 3A and FIG. 3B are top views of several staircase structures of memory devices according to an embodiment of the present disclosure.
FIG. 4A to FIG. 4F are schematic cross-sectional views illustrating a method of fabricating method of a memory device according to another embodiment of the present disclosure.
FIG. 5A and FIG. 5B are top views of several staircase structures of memory devices according to another embodiment of the present disclosure.

### DESCRIPTION OF THE EMBODIMENTS

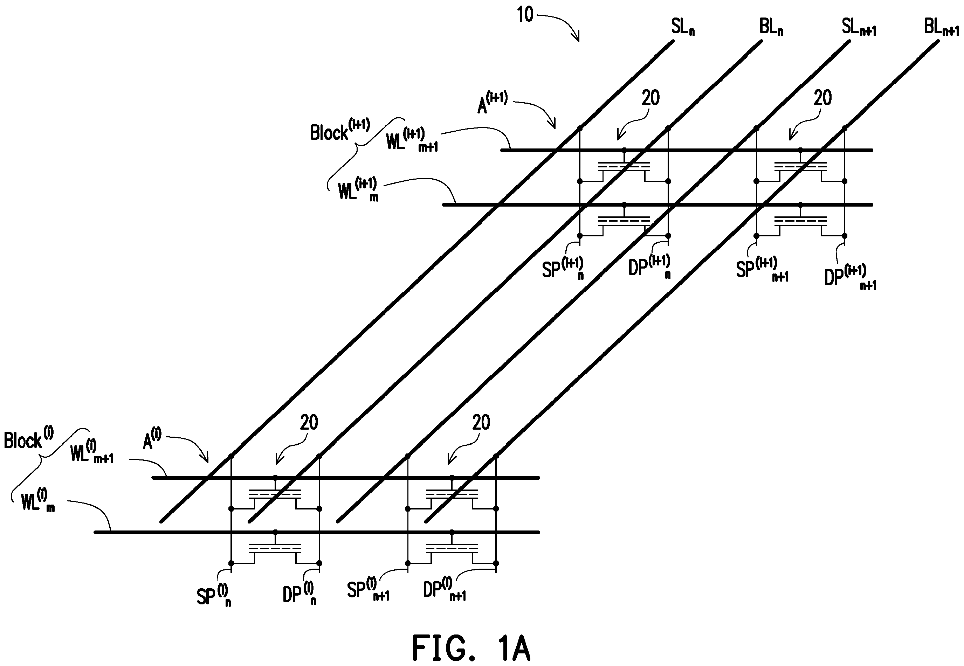

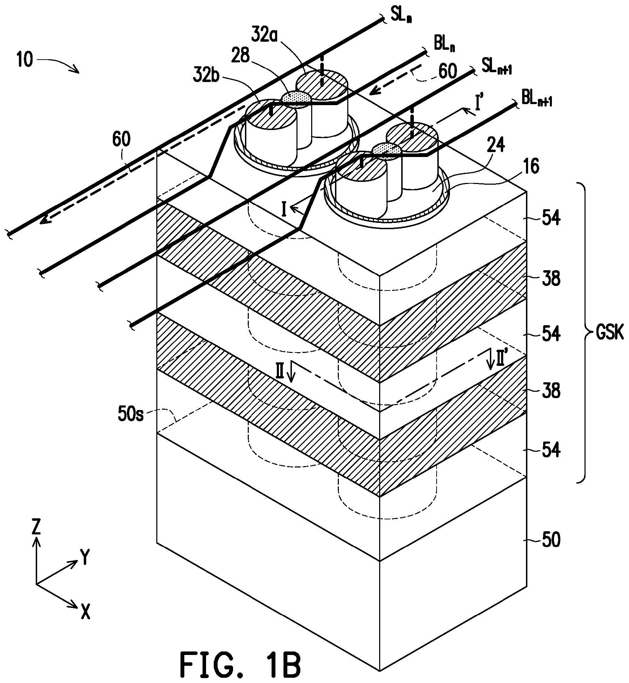

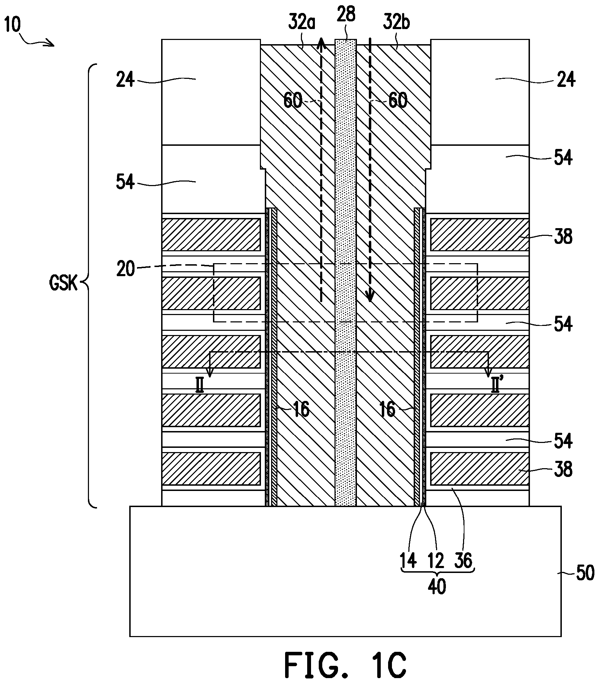

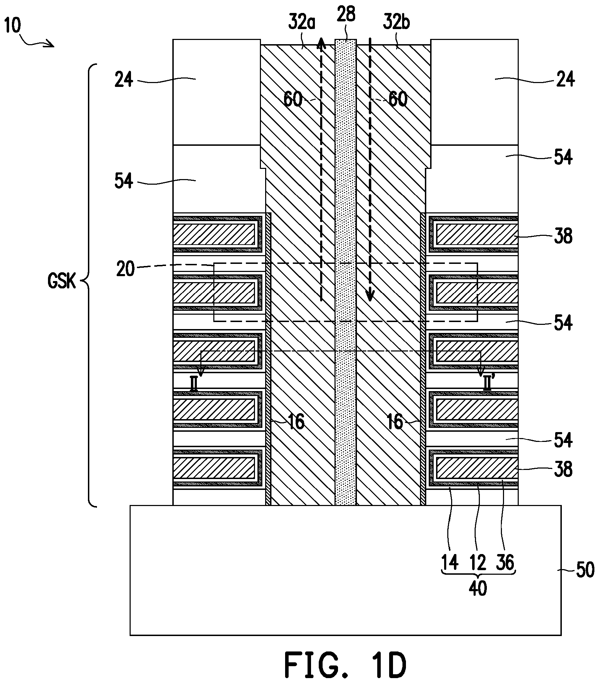

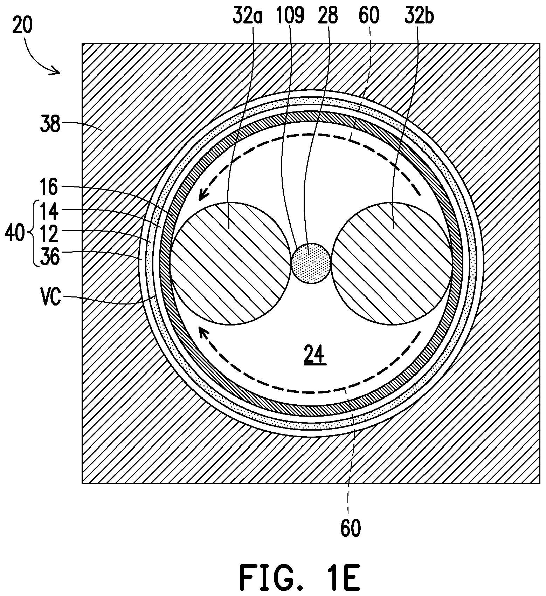

FIG. 1A is a circuit diagram of a three-dimensional AND flash memory array according to some embodiments. FIG. 1B is a partial perspective view of a part of the memory array in FIG. 1A. FIG. 1C and FIG. 1D are cross-sectional views taken along line I-I' of FIG. 1B. FIG. 1E is a top view of line II-II' of FIG. 1B, FIG. 1C, and FIG. 1D.

FIG. 1A is a schematic view of two blocks BLOCK⁽ⁱ⁾ and BLOCK⁽ⁱ⁺¹⁾ of a vertical AND memory array 10 arranged in rows and columns. The block BLOCK⁽ⁱ⁾ includes a memory array A⁽ⁱ⁾. A row (e.g., an (m+1)^{th} row) of the memory array A⁽ⁱ⁾ is a set of AND memory cells 20 having a common word line (e.g., WL⁽ⁱ⁾ₘ₊₁). The AND memory cells 20 of the memory array A⁽ⁱ⁾ in each row (e.g., the (m+1)^{th} row) correspond to a common word line (e.g., WL⁽ⁱ⁾ₘ₊₁) and are coupled to different source pillars (e.g., SP⁽ⁱ⁾ₙ and SP⁽ⁱ⁾ₙ₊₁) and drain pillars (e.g., DP⁽ⁱ⁾ₙ and DP⁽ⁱ⁾ₙ₊₁), so that the AND memory cells 20 are logically arranged in a row along the common word line (e.g., WL⁽ⁱ⁾ₘ₊₁).

A column (e.g., an n^{th} column) of the memory array A⁽ⁱ⁾ is a set of AND memory cells 20 having a common source pillar (e.g., SP⁽ⁱ⁾ₙ) and a common drain pillar (e.g., DP⁽ⁱ⁾ₙ). The AND memory cells 20 of the memory array A⁽ⁱ⁾ in each column (e.g., the n^{th} column) correspond to different word lines (e.g., WL⁽ⁱ⁾ₘ₊₁ and WL⁽ⁱ⁾ₘ) and are coupled to a common source pillar (e.g., SP⁽ⁱ⁾ₙ) and a common drain pillar (e.g., DP⁽ⁱ⁾ₙ). Hence, the AND memory cells 20 of the memory array A⁽ⁱ⁾ are logically arranged in a column along the common source pillar (e.g., SP⁽ⁱ⁾ₙ) and the common drain pillar (e.g., DP⁽ⁱ⁾ₙ). In the physical layout, according to the fabrication method as applied, the columns or rows may be twisted and arranged in a honeycomb pattern or other patterns for high density or other reasons.

In FIG. 1A, in the block BLOCK⁽ⁱ⁾, the AND memory cells 20 in the n^{th} column of the memory array A⁽ⁱ⁾ share a common source pillar (e.g., SP⁽ⁱ⁾ₙ) and a common drain pillar (e.g., DP⁽ⁱ⁾ₙ). The AND memory cells 20 in an (n+1)^{th} column share a common source pillar (e.g., SP⁽ⁱ⁾ₙ₊₁) and a common drain pillar (e.g., DP⁽ⁱ⁾ₙ₊₁).

The common source pillar (e.g., SP⁽ⁱ⁾ₙ) is coupled to a common source line (e.g., SLₙ) and the common drain pillar (e.g., DP⁽ⁱ⁾ₙ) is coupled to a common bit line (e.g., BLₙ). The common source pillar (e.g., SP⁽ⁱ⁾ₙ₊₁) is coupled to a common source line (e.g., SLₙ₊₁) and the common drain pillar (e.g., DP⁽ⁱ⁾ₙ₊₁) is coupled to a common bit line (e.g., BLₙ₊₁).

Likewise, the block BLOCK⁽ⁱ⁺¹⁾ includes a memory array A⁽ⁱ⁺¹⁾, which is similar to the memory array A⁽ⁱ⁾ in the block BLOCK⁽ⁱ⁾. A row (e.g., an (m+1)^{th} row) of the memory array A⁽ⁱ⁺¹⁾ is a set of AND memory cells 20 having a common word line (e.g., WL⁽ⁱ⁺¹⁾ₘ₊₁). The AND memory cells 20 of the memory array A⁽ⁱ⁺¹⁾ in each row (e.g., the (m+1)^{th} row) correspond to a common word line (e.g., WL⁽ⁱ⁺¹⁾ₘ₊₁) and are coupled to different source pillars (e.g., SP⁽ⁱ⁺¹⁾ₙ and SP⁽ⁱ⁺¹⁾ₙ₊₁) and drain pillars (e.g., DP⁽ⁱ⁺¹⁾ₙ and DP⁽ⁱ⁺¹⁾ₙ₊₁). A column (e.g., an n^{th} column) of the memory array A⁽ⁱ⁺¹⁾ is a set of AND memory cells 20 having a common source pillar (e.g., SP⁽ⁱ⁺¹⁾ₙ) and a common drain pillar (e.g., DP⁽ⁱ⁺¹⁾ₙ). The AND memory cells 20 of the memory array A⁽ⁱ⁺¹⁾ in each column (e.g., the n^{th} column) correspond to different word lines (e.g., WL⁽ⁱ⁺¹⁾ₘ₊₁ and WL⁽ⁱ⁺¹⁾ₘ) and are coupled to a common source pillar (e.g., SP⁽ⁱ⁺¹⁾ₙ) and a common drain pillar (e.g., DP⁽ⁱ⁺¹⁾ₙ). Hence, the AND memory cells 20 of the memory array A⁽ⁱ⁺¹⁾ are logically arranged in a column along the common source pillar (e.g., SP⁽ⁱ⁺¹⁾ₙ) and the common drain pillar (e.g., DP⁽ⁱ⁺¹⁾ₙ).

The block BLOCK⁽ⁱ⁺¹⁾ and the block BLOCK⁽ⁱ⁾ share source lines (e.g., SLₙ and SLₙ₊₁) and bit lines (e.g., BLₙ and BLₙ₊₁). Therefore, the source line SLₙ and the bit line BLₙ are coupled to the n^{th} column of AND memory cells 20 in the AND memory array A⁽ⁱ⁾ of the block BLOCK⁽ⁱ⁾, and are coupled to the n^{th} column of AND memory cells 20 in the AND memory array A⁽ⁱ⁺¹⁾ of the block BLOCK⁽ⁱ⁺¹⁾. Similarly, the source line SLₙ₊₁ and the bit line BLₙ₊₁ are coupled to the (n+1)^{th} column of AND memory cells 20 in the AND memory array A⁽ⁱ⁾ of the block BLOCK⁽ⁱ⁾, and are coupled to the (n+1)^{th} column of AND memory cells 20 in the AND memory array A⁽ⁱ⁺¹⁾ of the block BLOCK⁽ⁱ⁺¹⁾.

Referring to FIG. 1B to FIG. 1D, the memory array 10 may be disposed over an interconnection structure of a semiconductor die, for example, being disposed on one or more active devices (e.g., transistors) formed on a semiconductor substrate. Therefore, a dielectric substrate (or called dielectric layer) 50 may be a dielectric layer (e.g., a silicon oxide layer) over a metal interconnection structure formed on a silicon substrate. The memory array 10 may include a stacked structure GSK, multiple channel pillars 16, multiple first conductive pillars (also referred to as source pillars) 32a, multiple second conductive pillars (also referred to as drain pillars) 32b, and multiple charge storage structures 40.

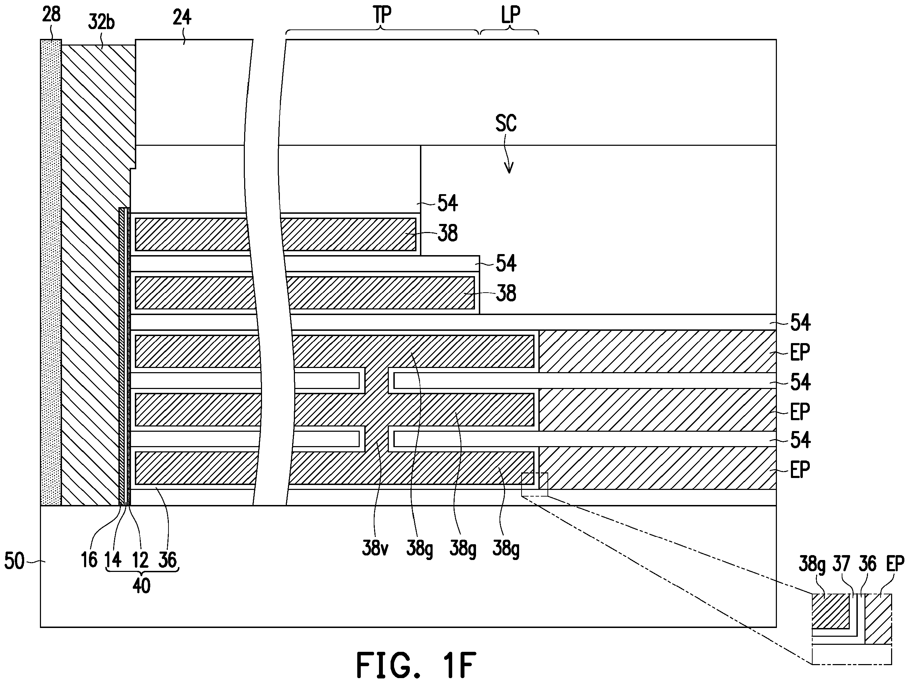

Referring to FIG. 1B, the stacked structure GSK is formed on a dielectric substrate 50. The stacked structure GSK includes multiple gate layers (also referred to as word lines or conductive layers) 38 and multiple insulating layer 54 vertically stacked on a surface 50s of the dielectric substrate 50. In a direction Z, the gate layers 38 are electrically insulated from each other by the insulating layer 54 disposed therebetween. The gate layers 38 extend in a direction parallel to the surface of the dielectric substrate 50. The gate layers 38 in the staircase region SR may have a staircase structure SC, as shown in FIG. 1F to FIG. 1I. Therefore, a lower gate layer 38 is longer than an upper gate layer 38, and the end of the lower gate layer 38 extends laterally beyond the end of the upper gate layer 38. Contacts (not shown) for connecting the gate layers 38 may be landed on the ends of the gate layers 38 to connect the gate layers 38 respectively to conductive lines.

Referring to FIG. 1B to FIG. 1D, the memory array 10 further includes multiple channel pillars 16. In some embodiments, each channel pillar 16 may have a ring shape from a top view. The material of the channel pillars 16 may include semiconductor, such as undoped polysilicon.

Referring to FIG. 1B to FIG. 1D, the memory array 10 further includes multiple insulating pillars 28, multiple first conductive pillars 32a, and multiple second conductive pillars 32b. In this example, the first conductive pillars 32a serve as source pillars. The second conductive pillars 32b serve as drain pillars. The first conductive pillars 32a, the second conductive pillars 32b, and the insulating pillars 28 each extend in a direction (i.e., the direction Z) perpendicular to the surface (i.e., the X-Y plane) of the gate layers 38. The first conductive pillar 32a and the second conductive pillar 32b are separated by the insulating pillar 28 and surrounded by an insulating filling layer 24. The first conductive pillar 32a and the second conductive pillar 32b are electrically connected to the channel pillar 16. The first conductive pillar 32a and the second conductive pillar 32b may include doped polysilicon or metal materials. The insulating pillar 28 may include silicon nitride or silicon oxide, and the insulating filling layer 24 may include silicon oxide.

Referring to FIG. 1C and FIG. 1D, a charge storage structure 40 is disposed between the channel pillar 16 and the gate layers (or called conductive layers) 38. The charge storage structure 40 may include a tunneling layer (or referred to as a bandgap engineered tunneling oxide layer) 14, a charge storage layer 12, and a blocking layer 36. The charge storage layer 12 is located between the tunneling layer 14 and the blocking layer 36. In some embodiments, the tunneling layer 14 and the blocking layer 36 include silicon oxide. The charge storage layer 12 includes silicon nitride or other materials capable of trapping charges. In some embodiments, as shown in FIG. 1C, a portion (e.g., the tunneling layer 14 and the charge storage layer 12) of the charge storage structure 40 continuously extends in a direction (i.e., the direction Z) perpendicular to the gate layer 38, and another portion (e.g., the blocking layer 36) of the charge storage structure 40 surrounds the gate layer 38. In other embodiments, as shown in FIG. 1D, the charge storage structure 40 (e.g., the tunneling layer 14, the charge storage layer 12, and the blocking layer 36) surrounds the corresponding gate layer 38.

Referring to FIG. 1E, the charge storage structure 40, the channel pillar 16, the source pillar 32a, and the drain pillar 32b are surrounded by the gate layer 38, and a memory cell 20 is accordingly defined. According to different operation methods, a 1-bit operation or a 2-bit operation may be performed on the memory cell 20. For example, when a voltage is applied to the source pillar 32a and the drain pillar 32b, since the source pillar 32a and the drain pillar 32b are connected to the channel pillar 16, electrons may be transferred along the channel pillar 16 and stored in the entire charge storage structure 40. Accordingly, a 1-bit operation may be performed on the memory cell 20. In addition, for an operation involving Fowler-Nordheim tunneling, electrons or holes may be trapped in the charge storage structure 40 between the source pillar 32a and the drain pillar 32b. For an operation involving source side injection, channel-hot-electron injection, or band-to-band tunneling hot carrier injection, electrons or holes may be locally trapped in the charge storage structure 40 adjacent to one of the source pillar 32a and the drain pillar 32b. Accordingly, a single level cell (SLC, 1 bit) or multi-level cell (MLC, greater than or equal to 2 bits) operation may be performed on the memory cell 20.

During operation, a voltage is applied to a selected word line (gate layer) 38; for example, when a voltage higher than a corresponding threshold voltage (Vₜₕ) of the corresponding memory cell 20 is applied, a channel region of the channel pillar 16 intersecting the selected word line 38 is turned on to allow a current to enter the drain pillar 32b from the bit line BLₙ or BLₙ₊₁ (shown in FIG. 1B), flow to the source pillar 32a via the turned-on channel region (e.g., in a direction indicated by arrow 60), and finally flow to the source line SLₙ or SLₙ₊₁ (shown in FIG. 1B).

FIG. 1F to FIG. 1I are schematic cross-sectional views of various staircase structures.

Referring to FIG. 1F to FIG. 1I, in some embodiments of the present disclosure, the conductive layers 38 of the upper stair part TP of the staircase structure SC can serve as word lines. The conductive layers 38g of the lower stair part LP of the staircase structure SC can be used to close the leakage path. The end of the lower stair part LP is connected to the extension part EP of the staircase structure SC. The resistance value of the extension part EP is different from the resistance value of the adjacent conductive layer 38g. The conductive layer 38g includes tungsten, for example. The extension part EP includes semiconductor, such as polysilicon.

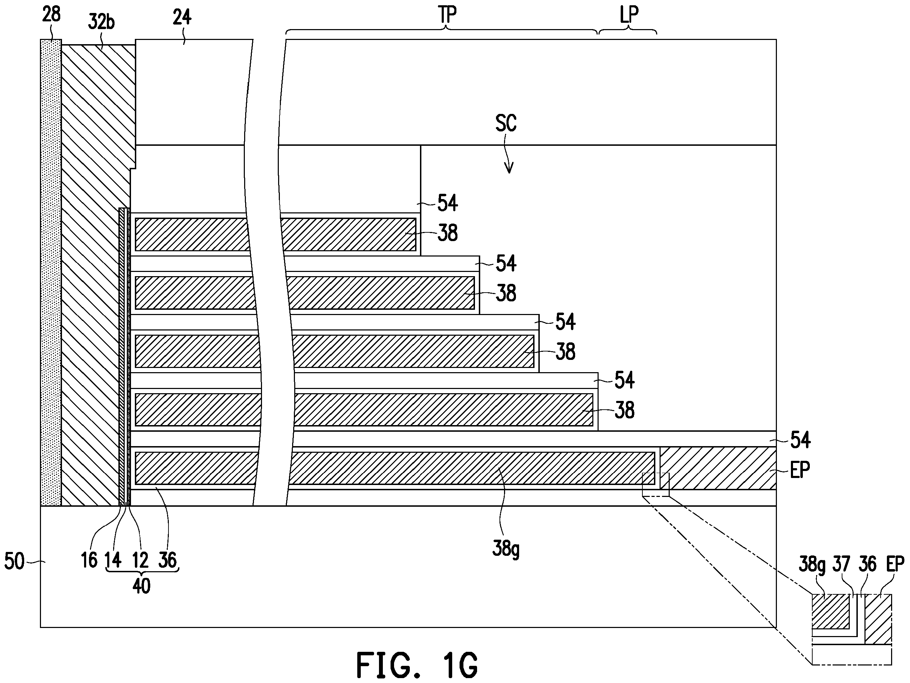

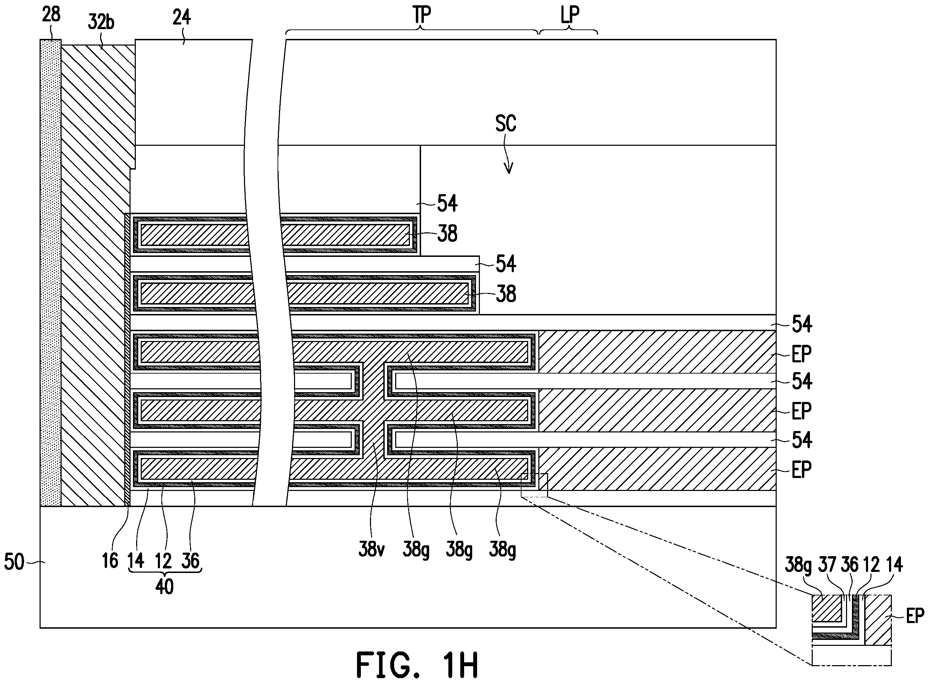

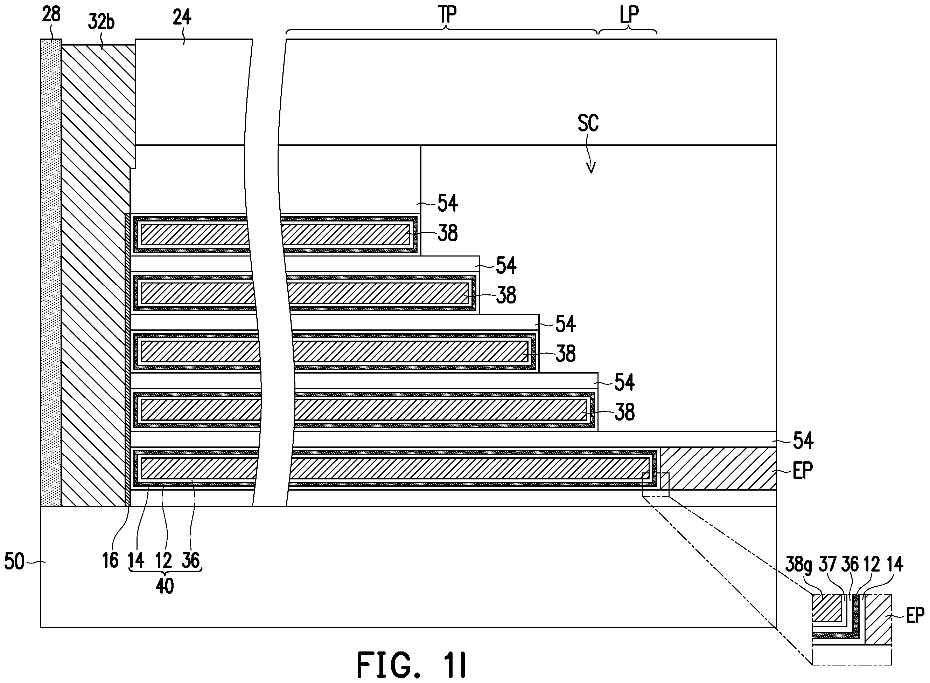

Referring to FIG. 1F and FIG. 1G, in some embodiments, the extension part EP and the adjacent conductive layer 38g can be electrically insulated from each other by a blocking layer 36 of the charge storage structure 40. Referring to FIG. 1H and FIG. 1I, in some other embodiments, the extension part EP and the adjacent conductive layer 38g can be electrically insulated from each other by a blocking layer 36, a charge storage layer 12 and a tunneling layer 14 of the charge storage structure 40.

Referring to FIG. 1F and FIG. 1H, the extension part EP may include multiple layers. Referring to FIG. 1G and FIG. 1I, the extension part EP can also be a single layer. Each layer of the extension part EP is connected to one gate layer 38g of the lower stair part LP. In addition, the conductive layers 38g of the lower stair part LP are electrically connected to each other through the connection part 38v. In some embodiments, a barrier layer 37 may also be included between each gate layer 38g of the lower stair part LP. The barrier layer 37 is located between gate layer 38g and blocking layer 36. The material of the barrier layer 37 includes titanium (Ti), titanium nitride (TiN), tantalum (Ta), tantalum nitride (TaN) or a combination thereof.

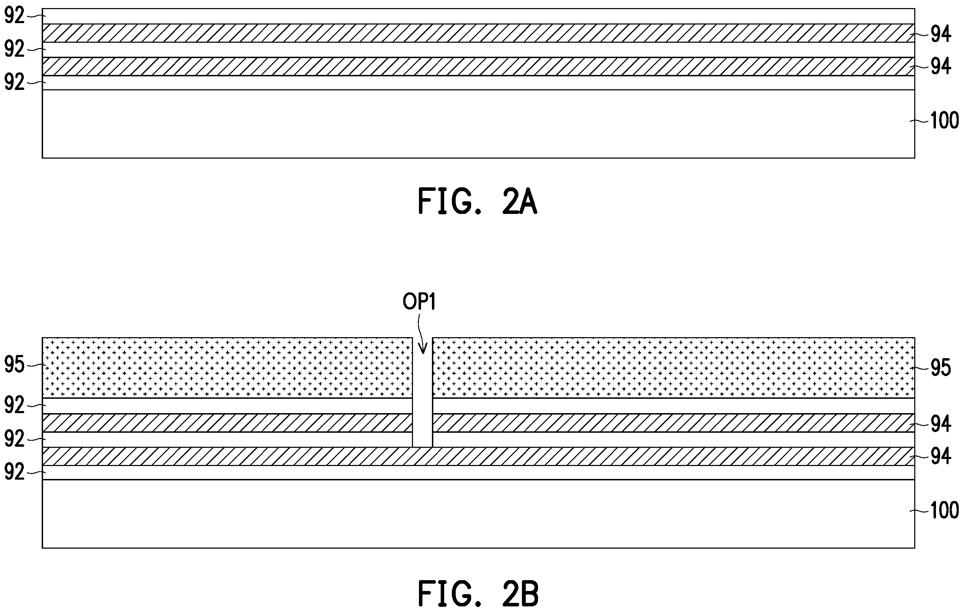

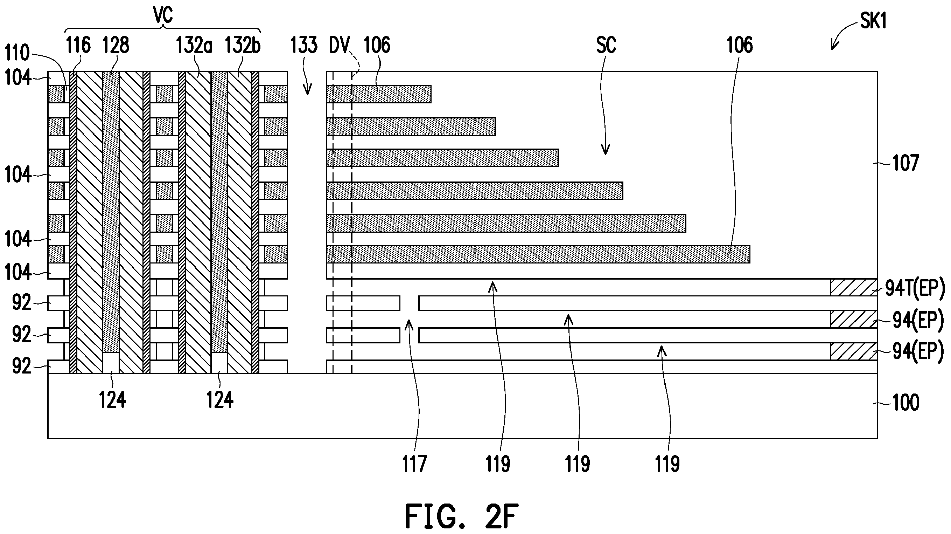

FIG. 2A to FIG. 2I are schematic cross-sectional views illustrating a method of fabricating a memory device according to an embodiment of the present disclosure.

Referring to Figure 2A, a dielectric substrate 100 is provided. The dielectric substrate 100 is, for example, a dielectric layer of an interconnection structure formed on a silicon substrate. The material of the dielectric substrate 100 includes silicon oxide. Multiple insulating layers 92 and multiple semiconductor layers 94 are stacked alternately on the dielectric substrate 100. Each insulating layer 92 includes a silicon oxide layer. Each semiconductor layer 94 includes a doped polysilicon layer. In this embodiment, there are three insulating layer 92 and two semiconductor layer 94, but the present disclosure is not limited thereto. In other embodiments, more or fewer insulating layers 92 and more or fewer semiconductor layers 94 can be formed according to actual needs.

Referring to FIG. 2B, a mask layer 95 is formed on the dielectric substrate 100. The mask layer 95 has an opening. The opening can have various shapes such as circle, ellipse, square, rectangle, etc. Afterwards, an etching process is performed to transfer the opening to the underlying insulating layers 92 and semiconductor layers 94 to form an opening OP1. The opening OP1 can be a connection opening or a connection trench. The opening OP1 can expose the lowermost semiconductor layer 94.

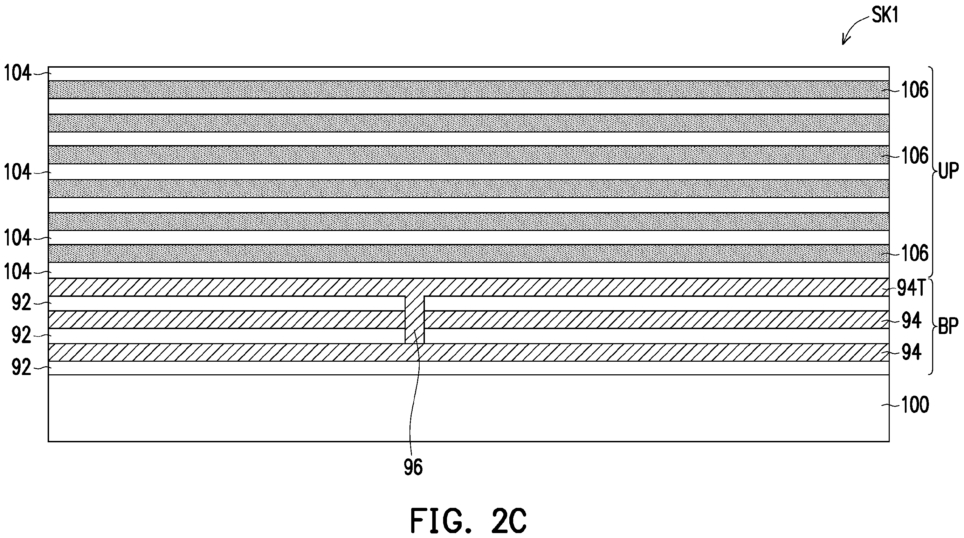

Referring to FIG. 2B and FIG. 2C, the mask layer 95 is removed. Next, another semiconductor layer 94T is formed on the insulating layer 92. The semiconductor layer 94T further fills in the opening OP1 to form a connection part 96. In addition, the semiconductor layer 94T can be grounded and serve as a discharge path. The insulating layer 92 and semiconductor layers 94 and 94T together form a lower part BP of a stacked structure SK1.

Referring to FIG. 2C, an upper part UP of the stacked structure SK1 is formed on the lower part BP of the stacked structure SK1. In this embodiment, the upper part UP of the stacked structure SK1 includes multiple insulating layers 104 and multiple intermediate layer 106 alternately stacked on the lower part BP of the stacked structure SK1. Each insulating layer 104 includes a silicon oxide layer. Each intermediate layer 106 includes a silicon nitride layer. The intermediate layers 106 can serve as sacrificial layers, which can be completely or partially removed in subsequent processes. In this embodiment, the stacked structure SK1 has seven insulating layers 104 and six intermediate layers 106, but the present disclosure is not limited thereto. In other embodiments, more insulating layers 104 and more intermediate layers 106 can be formed according to actual needs.

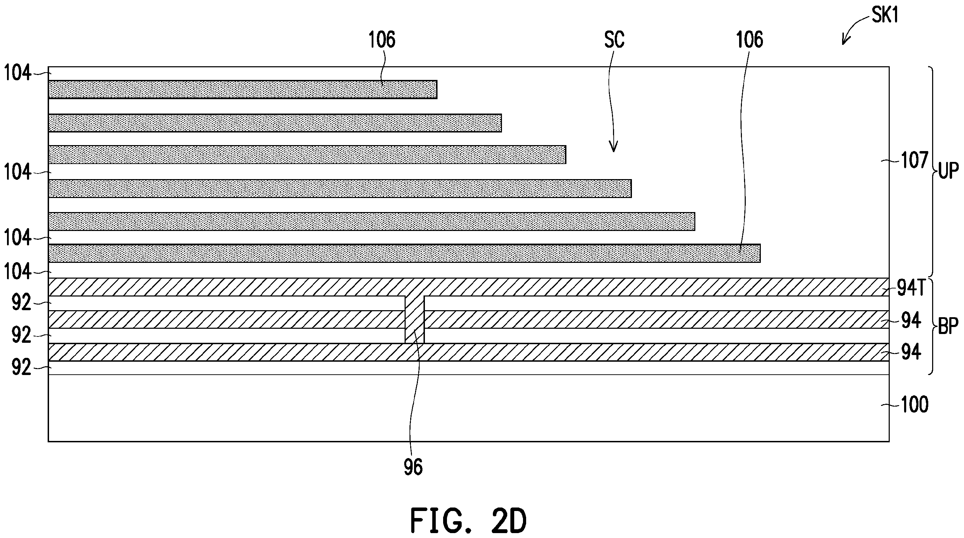

Referring to FIG. 2D, the upper part UP of the stacked structure SK1 is patterned while the lower part BP of the stacked structure SK1 is not patterned, so as to form a staircase structure SC. The lengths of multiple intermediate layers 106 are gradually increased from top to bottom, and the lengths of multiple semiconductor layers 94 are substantially the same. After that, a dielectric layer 107 is formed on the dielectric substrate 100. The dielectric layer 107 covers the staircase structure SC. The dielectric layer 107 can have a flat surface upon a chemical mechanical polishing process. The lowermost insulating layers 104 of the upper part UP of the stacked structure SK1 completely covers the lower part BP of the stacked structure SK1.

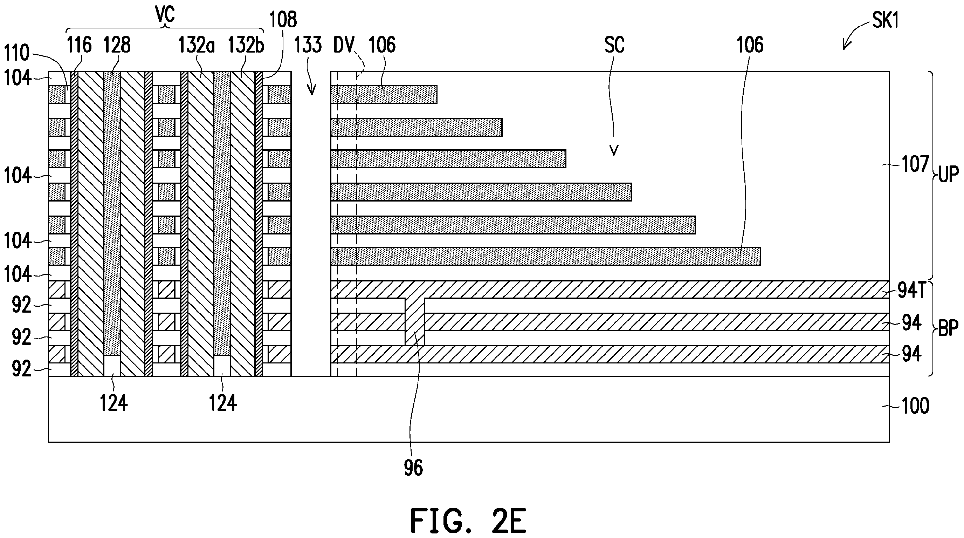

Referring to FIG. 2E, lithography and etching processes are performed to form multiple openings 108 in the stacked structure SK1 in an array region (not shown). Each opening 108 extends from the upper part UP to the lower part BP of the stacked structure SK1. The opening 108 has a circular profile, but the disclosure is not limited thereto. In other embodiments, the opening 108 may have another shape profile, such as a polygon (not shown). The etching process may include a dry etching process. During the dry etching process, the semiconductor layer 94T can serve as a conduction path for charges.

Referring to FIG. 2E, protection layers 110 are formed on the sidewalls of the semiconductor layers 94 and the intermediate layers 106. Each protection layer 110 includes a silicon oxide layer. The method of forming the protection layers 110 includes a dry thermal oxidation process, a wet thermal oxidation process or a combination thereof. Next, a channel pillar 116 is formed in each opening 108. The material of the channel pillar 116 includes semiconductor, such as undoped polysilicon. The method of forming the channel pillar 116 includes forming a channel material on the stacked structure SK1 and in the opening 108. Next, an etching back process is performed to partially remove the channel material to form the channel pillar 116.

Referring to FIG. 2E, an insulating filling layer 124 and an insulating pillar 128 are formed in each opening 108. The material of the insulating filling layer 124 includes silicon oxide, and the forming method includes a low temperature thermal oxidation method. The material of the insulating pillar 128 includes silicon nitride, and the forming method includes a chemical vapor deposition. The insulating filling layer 124 fills in the opening 108, and before it completely fills the opening 108, an insulating material different from the insulating filling layer 124 fills to completely seal the opening 108. The insulating material is etched back through a dry etching or a wet etching process until the surface of the insulating filling layer 124 is exposed, and thus, the insulating material left in the center of the opening 108 forms the insulating pillar 128.

Referring to FIG. 2E, a patterning process (e.g., lithography and etching processes) is performed to form holes (not shown) in the insulating filling layer 124. Next, conductive pillars 132a and 132b are formed in the holes. The conductive pillars 132a and 132b can serve as a source pillar and a drain pillar respectively, and are electrically connected to the channel pillar 116 respectively. The conductive pillars 132a and 132b can be formed by forming a conductive layer on the insulating filling layer 124 and in the holes, and followed by an etching back process. The conductive pillars 132a and 132b include doped polysilicon. The conductive pillars 132a and 132b, the channel pillar 116, the insulating pillar 128, and the insulating filling layer 124 may be collectively referred to as a vertical pillar VC.

Referring to FIG. 2E to FIG. 2H, a replacement process is performed to replace the multiple intermediate layer 106 and part of the semiconductor layers 94 with multiple conductive layers 138 and multiple charge storage structures 140. First, referring to FIG. 2E, a patterning process (e.g., lithography and etching processes) is performed on the stacked structure SK1 to form the separation trench 133 (or called a slit in some examples). The separation trench 133 extends from the upper part UP to the lower part BP of the stacked structure SK1. Afterwards, a multi-stage etching process is performed. First, a first stage etching process is performed to remove part of the semiconductor layers 94 to form multiple horizontal openings 119 and a connection opening 117. The etching process in the first stage can include a wet etching process. The etchant that can be used in the wet etching process includes ammonium hydroxide and hydrogen peroxide, such as chemical etchant SC1. The horizontal openings 119 may have approximately the same or different lengths. The lengths of multiple horizontal openings 119 are greater than the length of the lowest intermediate layer 106. Portions of the semiconductor layers 94 are left at the ends of the horizontal openings 119 to form multiple extension parts EP.

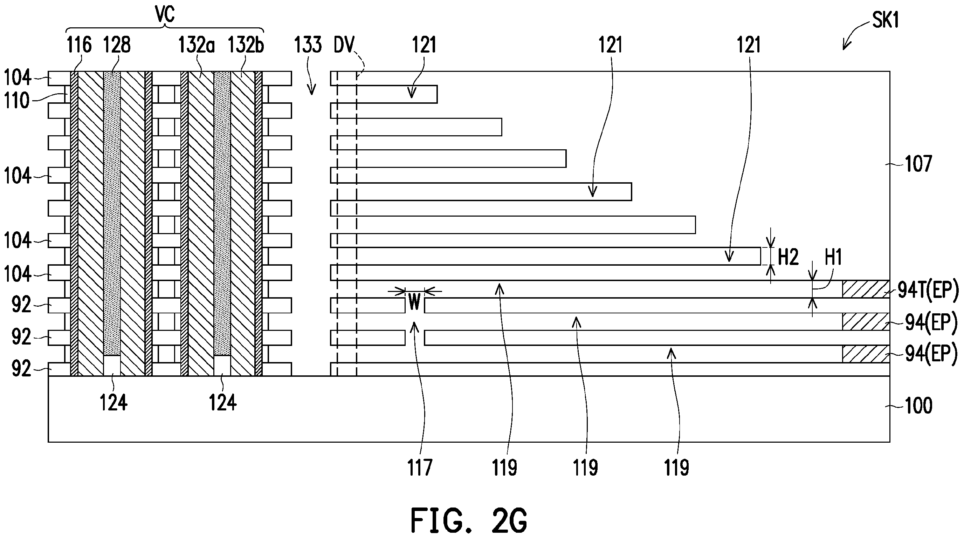

Referring to FIG. 2G, a second stage etching process of the multi-stage etching process is performed to remove part of the plurality of intermediate layers 106 to form multiple horizontal openings 121. The etching process in the second stage can include a wet etching process. The etchant used in the wet etching process includes hot phosphoric acid. During the etching process, since the material of the insulating layers 104 and the protection layers 110 is different from the material of the intermediate layers 106, the protection layers 110 can serve as stop layers.

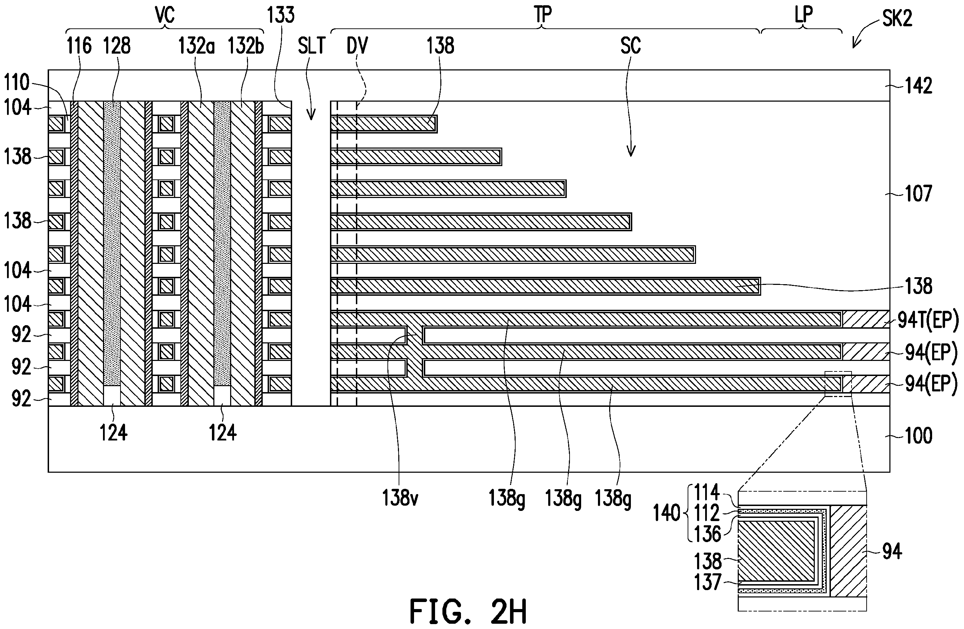

Referring to FIG. 2H, multiple charge storage structures 140 (each of which includes a tunneling layer 114, a storage layer 112, and a blocking layer 136), multiple barrier layers 137 and multiple conductive layers 138 are formed in the multiple horizontal openings 121 and 119. The tunneling layer 114 includes silicon oxide. The storage layer 112 includes silicon oxynitride, silicon nitride or a combination thereof. The blocking layer 136 includes silicon oxide, a material with a high dielectric constant greater than or equal to 7, or a combination thereof. The material with a high dielectric constant greater than or equal to 7 includes aluminum oxide (Al₂O₃), hafnium oxide (HfO₂), lanthanum oxide (La₂O₅), transition metal oxide, lanthanide oxide or a combination thereof. The material of each barrier layer 137 includes titanium (Ti), titanium nitride (TiN), tantalum (Ta), tantalum nitride (TaN) or a combination thereof. The material of each conductive layer 138 includes tungsten.

The method of forming the tunneling layer 114, the storage layer 112, the blocking layer 136, the barrier layer 137, and the conductive layer 138 includes sequentially forming a tunneling material, a storage material, a blocking material, a barrier material, and a conductive material. The thicknesses of the tunneling material, the storage material, the barrier material, the barrier material and the conductive material are sufficient to completely fill the horizontal openings 121, 119 and the connection opening 117. The height H1 of horizontal opening 119 is less than or equal to the height H2 of horizontal opening 121. The diameter (or width) W of the connection opening 117 is less than or equal to the heights H2, H1 of the horizontal openings 121, 119. Then, an etching back process is performed to remove the storage material, the blocking material, the barrier material and conductive material in the separation trench 133, so as to form the tunneling layer 114, the storage layer 112, the blocking layer 136, the barrier layer 137, and the conductive layer 138 in the horizontal openings 121 and 119 and the connection opening 117. The stacked structure SK2 and the staircase structure SC are thus formed. The lengths of the conductive layers 138 of the upper stair part TP of the staircase structure SC are gradually increased from top to bottom. The conductive layers 138g of the lower stair part LP of the staircase structure SC are adjacent to the extension parts EP, and the conductive layers 138g are separated from the extension parts EP by the charge storage structures 140.

Referring to FIG. 2H, a separation wall SLT is formed in the separation trench 133. The stacked structure SK2 is divided into multiple zones by the separation wall SLT. In some embodiments, the separation wall SLT may include an insulating layer 142. The forming method of the separation wall SLT includes forming an insulating material on the stacked structure SK2 filling in the separation trench 133, and then removing the excess insulating material through an etching back process or a planarization process. In other embodiments, the separation wall SLT further includes a filling layer (not shown) surrounded by the insulating layer 142. The filling layer can provide enough support to avoid bending of the separation wall SLT. The insulating layer 142 includes silicon oxide, and the filling layer includes polysilicon.

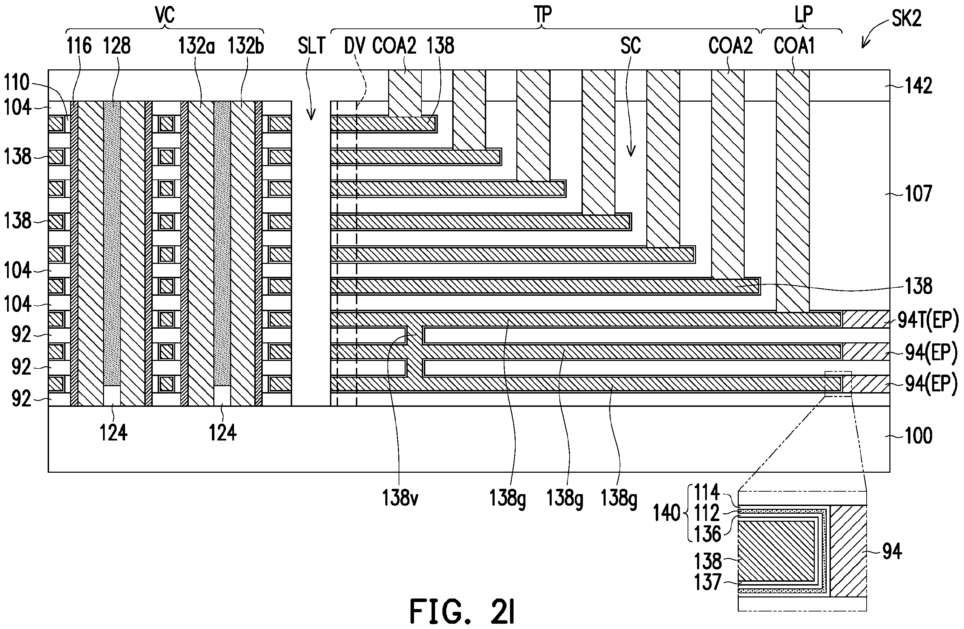

Referring to FIG. 2I, multiple contacts COA1 and COA2 are formed over the dielectric substrate 100. The contacts COA2 are landed on and electrically connected to the conductive layers 138 of the upper stair part TP of the staircase structure SC. The contact COA1 is landed on and electrically connected to the topmost conductive layer 138g of the lower stair part LP of the staircase structure SC.

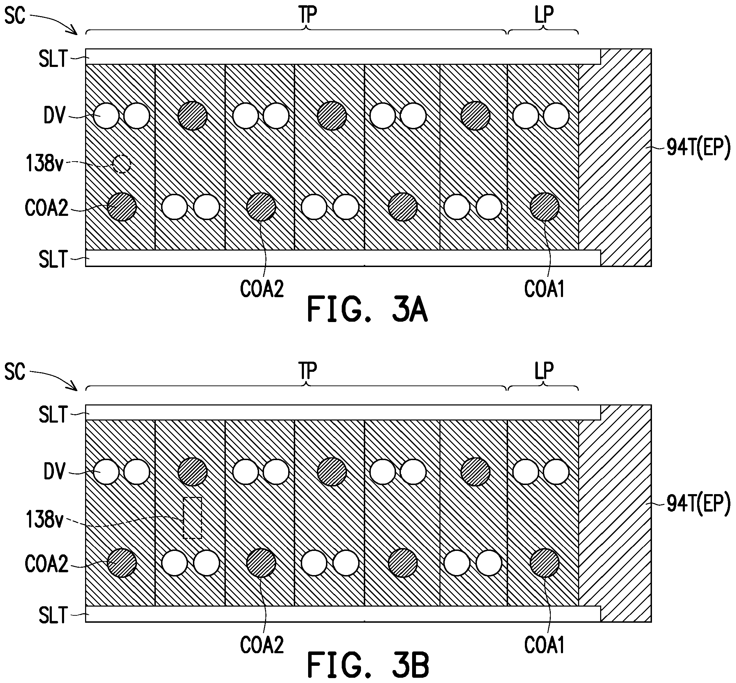

In the present disclosure, the barrier layers 137 and the conductive layers 138 of the upper part UP of the stacked structure SK2 serve as multiple word lines of the memory array. The stacked structure SK2 in the array region includes multiple memory cells. These memory cells are connected in parallel to each other through the conductive pillars 132a and 132b to form a memory string. The conductive layers 138 of the upper part UP of the stacked structure SK2 are electrically connected to the subsequently formed upper interconnection structure through the contacts COA2. The conductive layers 138g of the lower part BP of the stacked structure SK2 are connected to each other through the connection part 138v, and are electrically connected to the subsequently formed upper interconnection structure through the contact COA1. The conductive layers 138g can serve as gates or dummy gates. In some embodiments, no contact is landed on or electrically connected to the extension parts EP at the end of the lower stair part LP of the stacked structure SC, as shown in FIG. 3A and FIG. 3B.

FIG. 3A and FIG. 3B are top views of several staircase structures of memory devices according to an embodiment of the present disclosure.

Referring to FIG. 3A and FIG. 3B, the connection part 138v can be a connection hole (as shown in FIG. 3A) or a connection wall (as shown in FIG. 3B). The shape of the connection part 138v can be circular (as shown in FIG. 3A), strip-shaped (as shown in FIG. 3B) or oval (not shown), but the disclosure is not limited thereto. Referring to FIG. 3B, in the embodiment in which the connection part 138v is strip-shaped connection wall, the extending direction of the connection wall may be perpendicular to the extending direction of the separation wall SLT, but the disclosure is not limited thereto.

As shown in FIG. 3A and FIG. 3B, the connection part 138v can be disposed in an appropriate position. The connection part 138v can be disposed in the conductive layers 138 of the upper stair part TP (not shown) or in the conductive layers 138g and the insulating layers 92 of the lower stair part LP (shown in FIG. 2I).

Since the contacts COA2 are disposed on the upper surface of the conductive layer 138 of the upper stair part TP. The contact COA1 is disposed on the upper surface of the uppermost conductive layer 138g in the lower stair part LP. The connection part 138v is located between the lower surface of the uppermost conductive layer 138g and the upper surface of the lowermost conductive layer 138g. The position of connection part 138v does not affect the disposition of the contact COA1. Therefore, in the direction perpendicular to the dielectric substrate 100, the position of the connection part 138v may be staggered, partially overlapped or fully overlapped with the positions of the contacts COA1 or COA2.

Referring to FIG. 3A and FIG. 3B, in some embodiments, a support pillar DV (as shown in FIG. 2E to FIG. 2I) is further provided in the staircase structure SC, so as to prevent the staircase structure SC from collapsing during the gate replacement. For the sake of brevity, FIG. 2E only shows a single support pillar DV, but the present disclosure is not limited thereto. The staircase structure SC may include multiple support pillars DV, as shown in FIG. 3A and FIG. 3B. The support pillar DV can be formed at the same time during the formation of the vertical pillars VC (as shown in FIG. 2E to FIG. 2I), so the support pillar DV and the vertical pillars VC can have approximately the same height, that is, extending from the top surface of the dielectric layer 107 to the insulating layer 92. Alternatively, the support pillar DV may be formed at the same time during the formation of the through vias which connect the lower interconnection structure to the upper interconnection structure. In other words, the support pillar DV extends at least from the topmost layer to the bottommost layer of the staircase structure SC. Therefore, in order not to affect the disposition of the support pillar DV, the position of the connection part 138v and the position of the support pillar DV are staggered without overlapping, as shown in FIG. 3A and FIG. 3B.

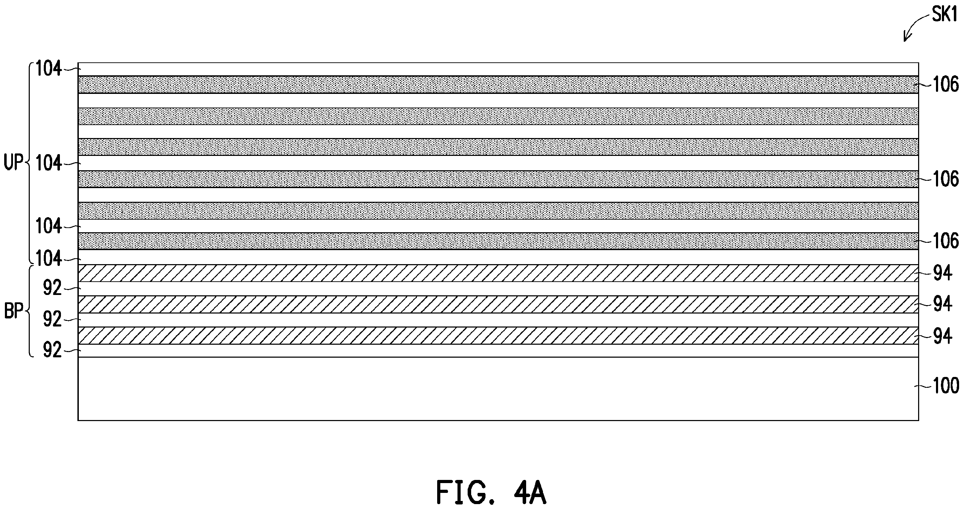

FIG. 4A to FIG. 4F are schematic cross-sectional views illustrating a method of a memory device according to another embodiment of the present disclosure.

Referring to FIG. 4A, a stacked structure SK1 is formed on a dielectric substrate 100. The stacked structure SK1 of FIG. 4A is similar to the stacked structure SK1 of the above embodiments, but does not include a connection part 96. The forming method of the stacked structure SK1 includes sequentially forming a lower part BP and an upper part UP. The lower part BP includes a plurality of insulating layers 92 and a plurality of semiconductor layers 94 stacked alternately. The lowermost semiconductor layer 94 can be grounded to serve as a conduction path for charges. The upper part UP includes a plurality of insulating layers 104 and a plurality of intermediate layers 106 stacked alternately. The materials of the insulating layers 92, the semiconductor layers 94, the insulating layers 104 and the intermediate layers 106 are similar to those described in the above embodiments.

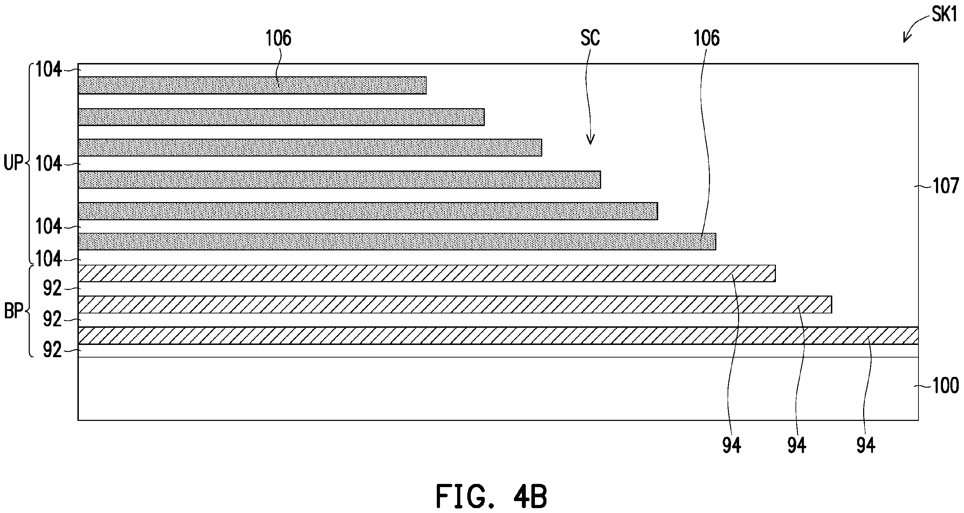

Referring to FIG. 4B, the upper part UP and the lower part BP of the stacked structure SK1 are patterned to form a staircase structure SC. In this embodiment, the lengths of the intermediate layers 106 of the staircase structure SC are gradually increased from top to bottom, and the lengths of the semiconductor layers 94 are gradually increased from top to bottom. After that, a dielectric layer 107 is formed on the dielectric substrate 100. The dielectric layer 107 covers the staircase structure SC.

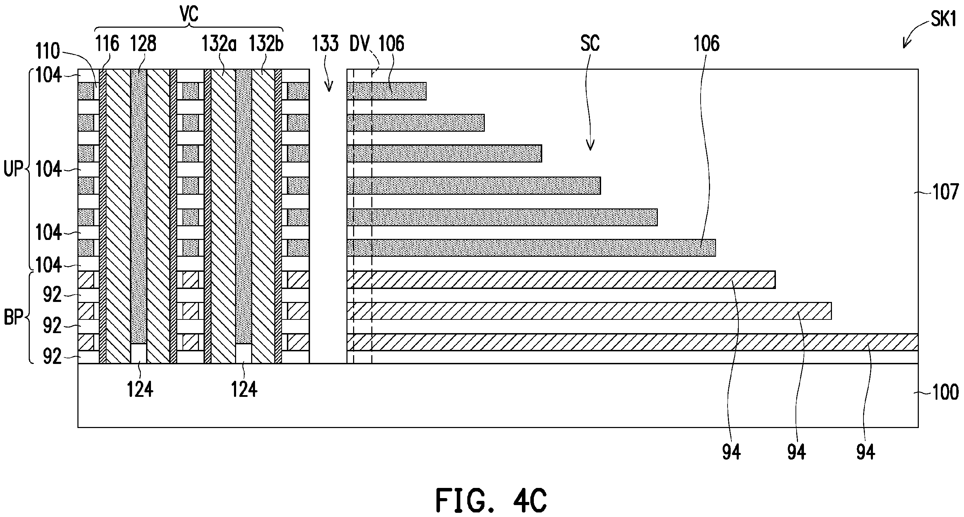

Referring to FIG. 4C, vertical pillars VC are formed in the stacked structure SK1 in an array region according to the above method.

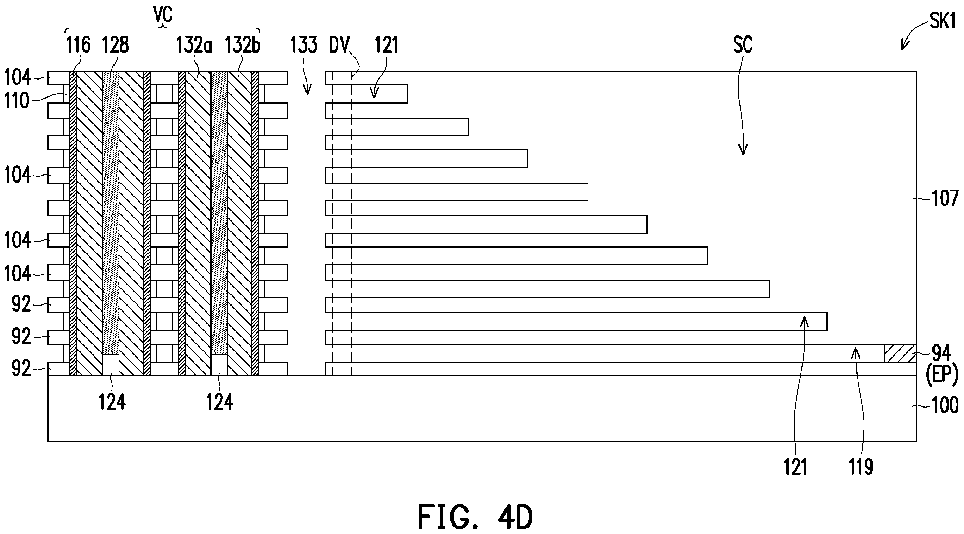

Referring to FIG. 4C to FIG. 4F, a replacement process is performed to replace the multiple intermediate layers 106 and the multiple semiconductor layers 94 with multiple conductive layers 138 and multiple charge storage structures 140. First, referring to FIG. 4C, a patterning process (e.g., lithography and etching processes) is performed to the stacked structure SK1 to form a separation trench 133. Next, referring to FIG. 4D, an etching process (e.g., a wet etching process) is performed to simultaneously remove part of the multiple intermediate layers 106 and part of the semiconductor layers 94 to form multiple horizontal openings 121 and 119. Part of the semiconductor layers 94 is left at the end of the lowest horizontal opening 119 to form an extension part EP.

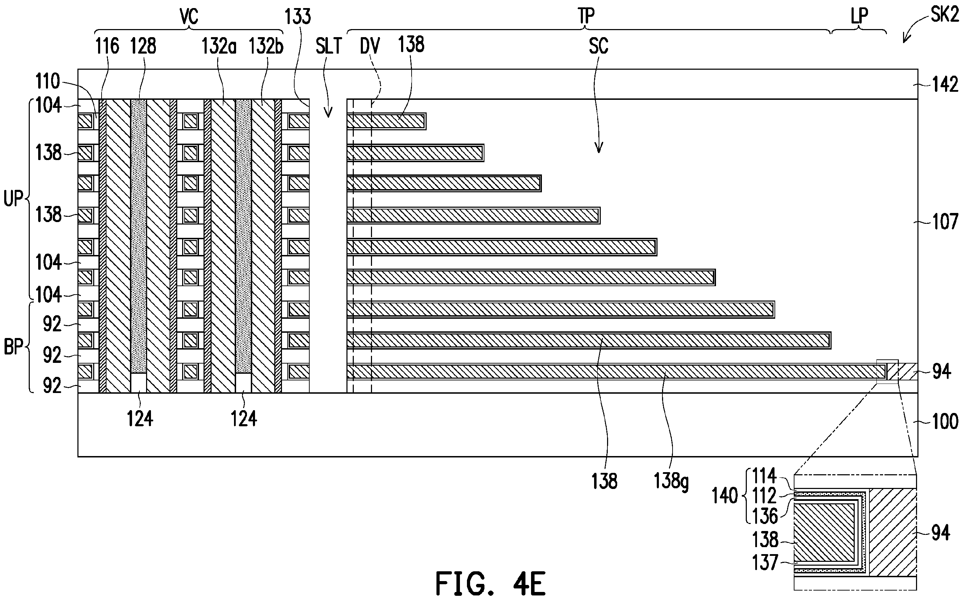

Referring to FIG. 4E, multiple charge storage structures 140 (each of which includes a tunneling layer 114, a storage layer 112, and a blocking layer 136), multiple barrier layers 137 and multiple conductive layers 138 are formed in the multiple horizontal openings 121 and 119 according to the above method. The stacked structure SK2 and the staircase structure SC are thus formed. The lengths of the conductive layers 138 of the upper stair part TP and the conductive layers 138g of the lower stair part LP of the staircase structure SC are gradually increased from top to bottom. The conductive layer 138g of the lower stair part LP of the staircase structure SC is adjacent to the extension part EP, and the conductive layer 138g and the extension part EP are separated from each other by a charge storage structure 140. Next, a separation wall SLT is formed in the separation trench 133.

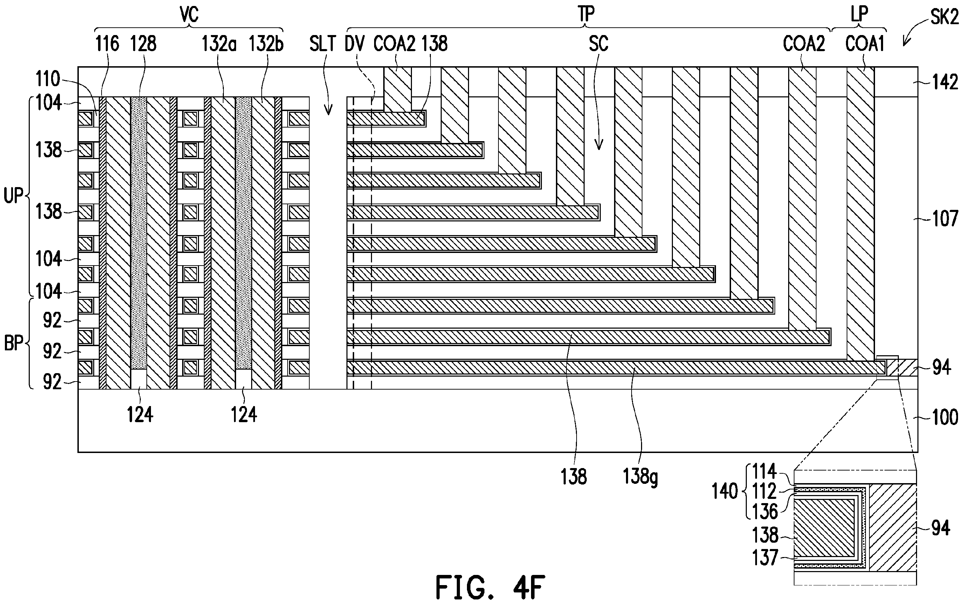

Referring to FIG. 4F, multiple contacts COA1 and COA2 are formed on the dielectric substrate 100 according to the above method. The contacts COA2 are landed on and electrically connected to the conductive layers 138 of the upper stair part TP of the staircase structure SC. The contact COA1 is landed on and electrically connected to the conductive layer 138g of the lower stair part LP of the staircase structure SC.

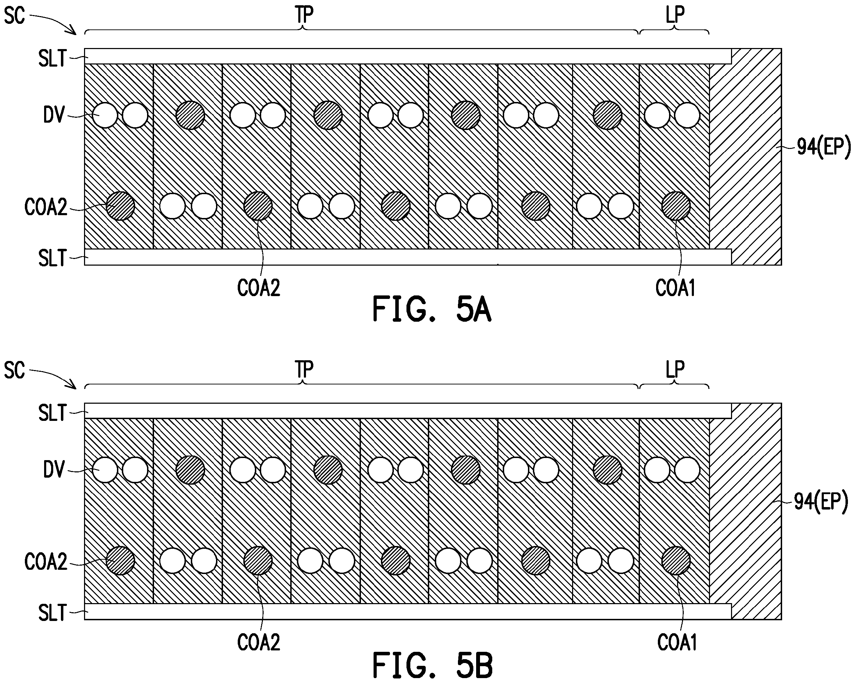

In the present disclosure, the barrier layers 137 and the conductive layers 138 of the upper part UP of the stacked structure SK2 serve as multiple word lines of the memory array. The stacked structure SK2 includes multiple memory cells. These memory cells are connected in parallel to each other through the conductive pillars 132a and 132b to form a memory string. The conductive layers 138 of the upper part UP are electrically connected to the subsequently formed upper interconnection structure through the contacts COA2. The lower part BP has a single conductive layer 138g, and is electrically connected to the subsequently formed upper interconnection structure via the contact COA1. The conductive layer 138g can serve as a gate or a dummy gate. In some embodiments, no contact is landed or electrically connected to the extension part EP at the end of the lower stair part LP of the staircase structure SC, as shown in FIG. 5A and FIG. 5B.

FIG. 5A and FIG. 5B are top views of several staircase structures of memory devices according to another embodiment of the present disclosure.

Top views of FIG. 5A and FIG. 5B are similar to top views of FIG. 3A and FIG. 3B, but the staircase structures SC of FIG. 5A and FIG. 5B are provided without a connection part. The upper stair part TP has more stairs, and the lower stair part LP adjacent to the extension part EP has less stairs or even a single stair.

The above embodiments are described by taking an AND flash memory as an example. The present disclosure can also be applied in a three-dimensional NOR flash memory and a three-dimensional NAND flash memory. The embodiments of the present disclosure not only can be applied in a flash memory, but also can be applied to various devices with staircase structures.

In the embodiment of the present disclosure, one or more semiconductor layers located at the lower part of the stacked structure can serve as a conduction path for charges to reduce the arc effect and prevent the various material layers and components on the dielectric substrate from being damaged by plasma bombardment. Therefore, the yield of the process can be improved. In addition, the one or more semiconductor layers can be subjected to a subsequent replacement process to form one or more conductive layers, which can serve as gate layers or dummy gate layers.

## Claims

1. A semiconductor device, comprising:
a staircase structure (SC) disposed on a dielectric substrate (100), wherein the staircase structure (SC) comprises a plurality of conductive layers (38, 38g, 138, 138g) and a plurality of insulating layers (54, 92) alternately stacked on each other; and
an extension part (EP, 94) located at an end of a lower stair part (LP) of the staircase structure (SC),
wherein a resistance value of the extension part (EP, 94) is different from a resistance value of the plurality of conductive layers (38, 38g, 138, 138g).

2. The semiconductor device according to claim 1, wherein the resistance value of the extension part (EP, 94) is higher than the resistance value of the plurality of conductive layers (38, 38g, 138, 138g).

3. The semiconductor device according to claim 1 or 2, wherein the extension part (EP, 94) comprises a semiconductor material, and the plurality of conductive layers (38, 38g, 138, 138g) comprise a metal material.

4. The semiconductor device according to claim 1, 2 or 3, further comprising:
a connection part (38v, 138v) located in the lower stair part (LP) and electrically connected to the conductive layers (38, 38g, 138, 138g) of the lower stair part (LP).

5. The semiconductor device according to claim 4, wherein a width of the connection part (38v, 138v) is less than a thickness of the conductive layers (38, 38g, 138, 138g).

6. The semiconductor device according to claim 4, further comprising:
a support pillar (DV) extending through the conductive layers (38, 38g, 138, 138g) and the insulating layers (54, 92) of the staircase structure (SC).

7. The semiconductor device according to claim 6, wherein the connection part (38v, 138v) is staggered with the support pillar (DV).

8. The semiconductor device according to claim 4, wherein the connection part (38v, 138v) comprises a connection via or a connection wall.

9. The semiconductor device according to claim 8, further comprising:
a separation wall (SLT) extending through the staircase structure (SC),
wherein an extending direction of the connection wall is different from an extending direction of the separation wall (SLT).

10. The semiconductor device according to claim 1, 2, 3 or 4, further comprising:
a channel pillar (16, 116) extending through the staircase structure (SC);
a plurality of conductive pillars (32a, 32b, 132a, 132b) located in the channel pillar (16, 116) and electrically connected to the channel pillar (16, 116); and
a charge storage layer (12, 112) located between the conductive layers (38, 38g, 138, 138g) and the channel pillar (16, 116),
wherein the charge storage layer (12, 112) is further located between the extension part (EP, 94) and the lower stair part (LP) of the staircase structure (SC).

11. The semiconductor device according to claim 1, 2, 3, 4 or 10, wherein among the plurality of conductive layers (38, 38g, 138, 138g), a thickness of the conductive layer (38g, 138g) connected to the extension part (EP, 94) is not greater than a thickness of the conductive layer (38, 138) not connected to the extension part (EP, 94).

12. A method of fabricating a semiconductor device, comprising:
forming a staircase structure (SC) on a dielectric substrate (100), wherein the staircase structure (SC) comprises a plurality of conductive layers (38, 38g, 138, 138g) and a plurality of insulating layers (54, 92) stacked alternately on each other; and
forming an extension part (EP, 94) at an end of a lower stair part (LP) of the staircase structure (SC),
wherein a resistance value of the extension part (EP, 94) is different from a resistance value of the plurality of conductive layers (38, 38g, 138, 138g).

13. The method according to claim 12, wherein forming the staircase structure (SC) comprises:
forming a plurality of semiconductor layers (94) and the plurality of insulating layers (92) stacked alternately on the dielectric substrate (100);
patterning the plurality of semiconductor layers (94) and the plurality of insulating layers (92) to form the staircase structure (SC); and
replacing part of the plurality of semiconductor layers (94) with the plurality of conductive layers (38, 38g, 138, 138g), and leaving part of the plurality of semiconductor layers (94) at the end of the lower horizontal opening (119) to form the extension part (EP).

14. The method according to claim 13, further comprising:
forming a first connection part (96) connecting the plurality of semiconductor layers (94);
removing the first connection part (96) to form a connection opening (117);
forming a conductive material in the connection opening (117) to form a second connection part (38v, 138v).

15. The method according to claim 14, wherein the connection opening (117) comprises a connection opening or a connection trench, and the second connection part (38v, 138v) comprises a connection via or a connection wall.

## Amended claims

### Amended claims in accordance with Rule 137(2) EPC.

1. A semiconductor device, comprising:
a staircase structure (SC) disposed on a dielectric substrate (100), wherein the dielectric substrate (100) is formed over a semiconductor substrate, the staircase structure (SC) comprises a plurality of conductive layers (38, 38g, 138, 138g) and a plurality of insulating layers (54, 92) alternately stacked on each other; and
an extension part (EP, 94);,
wherein a resistance value of a material of the extension part (EP, 94) is different from a resistance value of a material of each of the plurality of conductive layers (38, 38g, 138, 138g),
the semiconductor device being **characterized in that**
the extension part (EP, 94) is located at an outermost sidewall of an end of a lower stair part (LP) of the staircase structure (SC); and
the extension part (EP, 94) and the plurality of conductive layers (38, 38g, 138, 138g) have different materials and have an interface therebetween.

2. The semiconductor device according to claim 1, wherein the resistance value of the material of the extension part (EP, 94) is higher than the resistance value of the material of each of the plurality of conductive layers (38, 38g, 138, 138g).

3. The semiconductor device according to claim 1 or 2, wherein the extension part (EP, 94) comprises a semiconductor material, and the plurality of conductive layers (38, 38g, 138, 138g) comprise a metal material.

4. The semiconductor device according to claim 1, 2 or 3, further comprising:
a connection part (38v, 138v) located in the lower stair part (LP) and electrically connected to the conductive layers (38, 38g, 138, 138g) of the lower stair part (LP).

5. The semiconductor device according to claim 4, wherein a width of the connection part (38v, 138v) is less than a thickness of the conductive layers (38, 38g, 138, 138g).

6. The semiconductor device according to claim 4, further comprising:
a support pillar (DV) extending through the conductive layers (38, 38g, 138, 138g) and the insulating layers (54, 92) of the staircase structure (SC).

7. The semiconductor device according to claim 6, wherein the connection part (38v, 138v) is separated from the support pillar (DV) by a distance.

8. The semiconductor device according to claim 4, wherein the connection part (38v, 138v) comprises a connection via.

9. The semiconductor device according to claim 4, wherein the connection part (38v, 138v) comprises a connection wall and further comprising:
a separation wall (SLT) extending through the staircase structure (SC),
wherein an extending direction of the connection wall is different from an extending direction of the separation wall (SLT).

10. The semiconductor device according to claim 1, 2, 3 or 4, further comprising:
a channel pillar (16, 116) extending through the staircase structure (SC);
a plurality of conductive pillars (32a, 32b, 132a, 132b) located in the channel pillar (16, 116) and electrically connected to the channel pillar (16, 116); and
a charge storage layer (12, 112) located between the conductive layers (38, 38g, 138, 138g) and the channel pillar (16, 116),
wherein the charge storage layer (12, 112) is further located between the extension part (EP, 94) and the lower stair part (LP) of the staircase structure (SC).

11. The semiconductor device according to claim 1, 2, 3, 4 or 10, wherein among the plurality of conductive layers (38, 38g, 138, 138g), a thickness of the conductive layer (38g, 138g) connected to the extension part (EP, 94) is not greater than a thickness of the conductive layer (38, 138) not connected to the extension part (EP, 94).

12. A method of fabricating a semiconductor device, comprising:
forming a staircase structure (SC) on a dielectric substrate (100), wherein the dielectric substrate (100) is formed over a semiconductor substrate, the staircase structure (SC) comprises a plurality of conductive layers (38, 38g, 138, 138g) and a plurality of insulating layers (54, 92) stacked alternately on each other; and
forming an extension part (EP, 94),
wherein a resistance value of a material of the extension part (EP, 94) is different from a resistance value of a material of each of the plurality of conductive layers (38, 38g, 138, 138g); the method being **characterized in that**
the extension part (EP, 94) is formed at an outermost sidewall of an end of a lower stair part (LP) of the staircase structure (SC); and
the extension part (EP, 94) and the plurality of conductive layers (38, 38g, 138, 138g) have different materials and have an interface therebetween.

13. The method according to claim 12, wherein forming the staircase structure (SC) comprises:
forming a plurality of semiconductor layers (94) and a first part of the plurality of insulating layers (92) stacked alternately on the dielectric substrate (100);
forming a plurality of intermediate layers (106) and a second part of the plurality of insulating layers (92) stacked alternately;
patterning the plurality of intermediate layers (106) and the plurality of insulating layers (92) to form the staircase structure (SC); and
replacing part of the plurality of semiconductor layers (94) and the plurality of intermediate layers (106) with the plurality of conductive layers (38, 38g, 138, 138g), and leaving the staircase structure (SC) and part of the plurality of semiconductor layers (94) at an end of a lower horizontal opening (119) to form the extension part (EP).

14. The method according to claim 13, further comprising:
forming a first connection part (96) connecting the plurality of semiconductor layers (94);
removing the first connection part (96) to form a connection opening (117);
forming a conductive material in the connection opening (117) to form a second connection part (38v, 138v).

15. The method according to claim 14, wherein the connection opening (117) comprises a connection opening or a connection trench, and the second connection part (38v, 138v) comprises a connection via or a connection wall.
